(19) Europäisches Patentamt

European Patent Office

Office européen des brevets

(11) **EP 1 037 056 A1**

(12) **EUROPEAN PATENT APPLICATION**

(43) Date of publication:
20.09.2000 Bulletin 2000/38

(51) Int. Cl.⁷: **G01R 15/14**, G01R 33/02

(21) Application number: 00103840.5

(22) Date of filing: 24.02.2000

(84) Designated Contracting States:
**AT BE CH CY DE DK ES FI FR GB GR IE IT LI LU MC NL PT SE**
Designated Extension States:
**AL LT LV MK RO SI**

(30) Priority: 09.03.1999 JP 6241599

(71) Applicant:
**MITSUBISHI MATERIALS CORPORATION**
**Chiyoda-ku, Tokyo (JP)**

(72) Inventor:
**Yamamoto, Osamu,**
**c/o Central Research Institute**
**Omiya-shi, Saitama-ken (JP)**

(74) Representative:
**Gille Hrabal Struck Neidlein Prop Roos**
**Patentanwälte,**
**Brucknerstrasse 20**
**40593 Düsseldorf (DE)**

(54) **Current sensor**

(57) A current sensor is disclosed which can detect even a very small current in a highly reliable fashion using a simple construction. The current sensor includes a magnetic impedance element for generating a voltage corresponding to the intensity of a magnetic field generated around an electric wire through which a current to be detected is flowing, a circuit unit including a driving circuit for driving the magnetic impedance element, and a calculation unit for determining the value of the current flowing through the electric wire from the voltage generated by the magnetic impedance element. The magnetic impedance element is firmly disposed in a case made of a non-magnetic material. A magnetic shield is disposed along the perimeter of the case so as to block an external magnetic field which would otherwise can cause a disturbance. The magnetic field is detected by the magnetic impedance element having a high sensitivity, and thus the current flowing through the electric wire is detected in a highly reliable fashion.

FIG. 1A

FIG. 1B

EP 1 037 056 A1

**Description**

BACKGROUND OF THE INVENTION

1. Field of the Invention

The present invention relates to a current sensor for detecting a current flowing through an electric wire.

2. Description of the Related Art

One known technique for detecting a current flowing through an electric wire is to employ an ammeter. In this technique, an ammeter is installed in a particular part of a circuit including an electric wire through which a current to be detected is flowing (first conventional technique).

Another known technique is to measure a magnetic field generated around an electric wire, through which a current to be detected is flowing, and determine the current from the intensity of the magnetic field. In this technique, a magnetic sensor using a transformer, a coil, or a detection head such as an MR device or a Hall device is disposed in the vicinity of an electric wire through which a current to be detected is flowing so that the magnetic field generated around the electric wire through which the current is flowing is detected by the magnetic sensor. From the detection result, the current flowing through the electric wire is determined (second conventional technique).

However, to detect a current flowing a particular electric wire using the first conventional technique, installation of an ammeter is needed, which requires a modification of a circuit including the electric wire. This results in degradation in workability.

When a current is detected using a transformer or a coil according to the second conventional technique, it is impossible to detect a DC current, because the technique is based on detection of a change in a magnetic field by means of electromagnetic induction. Although it is possible to detect a DC current if a magnetic sensor using an MR device or a Hall device is employed as a detection head, the sensitivity of such a detection head is low, and thus it is required to dispose a magnetic circuit in the vicinity of the detection head. However, because of the hysteresis of the magnetic circuit, it is impossible to detect a small current.

In view of the above, it is an object of the present invention to provide a current sensor having a simple construction and capable of detecting even a small DC current in a highly relative fashion.

SUMMARY OF THE INVENTION

According to an aspect of the present invention, there is provided a current sensor comprising: a magnetic impedance element which is disposed a small distance apart from an electric wire through which a current to be detected is flowing so that the magnetic impedance element generates a voltage corresponding to the intensity of a magnetic field generated around the electric wire; a driving unit for supplying a current to the magnetic impedance element thereby driving the magnetic impedance element; and a calculation unit for determining the value of the current flowing through the electric wire from a voltage generated across the magnetic impedance element.

In the present invention, the magnetic impedance element is disposed in the vicinity of an electric wire through which a current to be detected is flowing so that the magnetic impedance element detects a magnetic field with an intensity corresponding to the current flowing through the electric wire and generates a voltage corresponding to the intensity of the magnetic field. The voltage generated by the magnetic impedance element is sent to the calculation unit. Data representing the relationship between the current flowing through the electric wire and the voltage output by the magnetic impedance element is stored in advance in the calculation unit. The calculation unit calculates the current flowing through the electric wire using the data described above. The result is then output from the calculation unit. As described above, the current flowing through the electric wire can be easily detected in a non-contact fashion by the magnetic impedance element. Because the operation of the magnetic impedance element is based on magnetoelectric conversion, it is possible to detect a DC current. Furthermore, because the magnetic impedance element has a high sensitivity, it is possible to detect a very small current without having to dispose a magnetic circuit in the vicinity of the magnetic impedance element.

According to another aspect of the present invention, there is provided a current sensor comprising: a plurality of magnetic impedance elements which are each disposed a small distance apart from an electric wire through which a current to be detected is flowing so that each magnetic impedance element generates a voltage corresponding to the intensity of a magnetic field generated around the electric wire; a driving unit for supplying a current to the plurality of magnetic impedance elements thereby driving the plurality of magnetic impedance elements; and a calculation unit for determining the value of the current flowing through the electric wire from voltages generated across the plurality of magnetic impedance elements.

The use of the plurality of magnetic impedance elements makes it possible to detect a smaller current by means of addition of the outputs of the respective magnetic impedance elements. Thus it is possible to realize a current sensor having a higher sensitivity.

In this current sensor according to the present invention, the plurality of magnetic impedance elements are preferably disposed at opposite sides of the electric wire.

The arrangement of the magnetic impedance elements at opposite sides of the electric wire through which a current to be detected is flowing makes it possible to correct a detection error due to a change in the distance between the magnetic impedance elements and the electric wire, by processing the outputs of the respective magnetic impedance elements using the calculation unit.

In the current sensor according to the present invention, it is preferable that the plurality of magnetic impedance elements be disposed at opposite sides such that the sensitivity directions thereof become parallel to each other.

Thus, in the current sensor according to the present invention, when a uniform external magnetic field is applied to the current sensor, effects of the external magnetic field on the plurality of magnetic impedance elements are equal, and thus it is possible to cancel the components of the external magnetic field by processing the outputs of the respective magnetic impedance elements using the calculation unit. This allows more precise detection of the current flowing through the electric wire.

According to still another aspect of the present invention, there is provided a current sensor comprising: a magnetic impedance element which is formed in an annular ring shape surrounding an electric wire through which a current to be detected is flowing and which generates a voltage corresponding to the intensity of a magnetic field generated around the electric wire; a driving unit for supplying a current to the magnetic impedance element thereby driving the magnetic impedance element; and a calculation unit for determining the value of the current flowing through the electric wire from a voltage generated across the magnetic impedance element.

The formation of the magnetic impedance element into the annular ring which surrounds the electric wire through which the current to be detected is flowing makes it possible to place the magnetic impedance element so that the sensitivity direction thereof becomes parallel to the direction of a magnetic field generated around the electric wire. Thus it becomes possible to detect the current in a highly reliable fashion.

According to still another aspect of the present invention, there is provided a current sensor comprising: a magnetic impedance element which is disposed a small distance apart from an electric wire through which a current to be detected is flowing so that the magnetic impedance element generates a voltage corresponding to the intensity of a magnetic field generated around the electric wire; a driving unit for supplying a current to the magnetic impedance element thereby driving the magnetic impedance element; and a calculation unit for determining the value of the current flowing through the electric wire from a voltage generated across the magnetic impedance element, the current sensor further comprising: a case made of a non-magnetic material, for firmly disposing the magnetic impedance element in the case; an electric wire holder formed in a part of the case so as to hold the electric wire; and a magnetic shield disposed along the perimeter of the case so as to block a magnetic field other than the magnetic field generated by the electric wire thereby preventing the magnetic impedance element from being disturbed by the magnetic field.

In this current sensor according to the present invention, because the magnetic impedance element is disposed in the case made of the non-magnetic material and the electric wire holder for holing the electric wire is formed in the part of the case, the magnetic field generated by the electric wire through which the current to be detected is flowing is applied to the magnetic impedance element via the case and detected by the magnetic impedance element. Furthermore, the magnetic shield disposed along the perimeter of the case makes it possible to block an external magnetic field which would otherwise disturb detection thereby ensuring precise and reliable detection of the current flowing through the electric wire. Furthermore, because the magnetic impedance element is firmly disposed in the case, the current sensor can be easily handled, and thus workability is improved.

According to still another aspect of the present invention, there is provided a current sensor comprising: a plurality of magnetic impedance elements which are each disposed a small distance apart from an electric wire through which a current to be detected is flowing so that each magnetic impedance element generates a voltage corresponding to the intensity of a magnetic field generated around the electric wire; a driving unit for supplying a current to the plurality of magnetic impedance elements thereby driving the plurality of magnetic impedance elements; and a calculation unit for determining the value of the current flowing through the electric wire from voltages generated across the plurality of magnetic impedance elements, said current sensor further comprising: a case made of a non-magnetic material, for firmly disposing the plurality of magnetic impedance elements in the case; an electric wire holder formed in a part of the case so as to hold the electric wire; and a magnetic shield disposed along the perimeter of the case so as to block a magnetic field other than the magnetic field generated by the electric wire thereby preventing the plurality of magnetic impedance elements from being disturbed by the magnetic field.

In this current sensor according to the present invention, because the plurality of magnetic impedance elements are disposed in the case made of the non-magnetic material and the electric wire is held by the electric wire holder formed in the part of the case, the magnetic field generated by the electric wire through which the current to be detected is flowing is applied to the plurality of magnetic impedance elements via the case and detected by them. This makes it possible to detect an even very small current flowing through the electric wire by determining the sum of the outputs of the respective magnetic impedance elements using the calculation unit. Thus it is possible to realize a high-sensitivity current sensor capable of detecting a very small current. Furthermore, the magnetic shield disposed along the perimeter of the case makes it possible to block an external magnetic field which would otherwise disturb detection thereby ensuring precise and reliable detection of the current flowing through the electric wire. Furthermore, because the magnetic impedance elements are firmly disposed in the case, the current sensor can be easily handled, and thus workability is improved.

According to still another aspect of the present invention, there is provided a current sensor comprising: a magnetic impedance element which is formed in an annular ring shape surrounding an electric wire through which a current to be detected is flowing and which generates a voltage corresponding to the intensity of a magnetic field generated around the electric wire; a driving unit for supplying a current to the magnetic impedance element thereby driving the magnetic impedance element; and a calculation unit for determining the value of the current flowing through the electric wire from a voltage generated across the magnetic impedance element, the current sensor further comprising: a case made of a non-magnetic material, for firmly disposing the magnetic impedance element in the case; an electric wire holder formed in the annular ring of the magnetic impedance element, for holding the electric wire; and a magnetic shield disposed along the perimeter of the case so as to block a magnetic field other than the magnetic field generated by the electric wire thereby preventing the magnetic impedance element from being disturbed by the magnetic field.

In this current sensor according to the present invention, because the magnetic impedance element in the form of the annular ring shape is disposed in the case made of the non-magnetic material and the electric wire holder for holing the electric wire is formed in the case, it is possible to make the sensitivity direction of the magnetic impedance element parallel to the direction of a magnetic field generated around the electric wire. Thus it becomes possible to detect the current in a highly reliable fashion. Furthermore, the magnetic shield disposed along the perimeter of the case makes it possible to block an external magnetic field which would otherwise disturb detection thereby ensuring precise and reliable detection of the current flowing through the electric wire. Furthermore, because the magnetic impedance element is firmly disposed in the case, the current sensor can be easily handled, and thus workability is improved.

According to still another aspect of the present invention, there is provided a current sensor comprising: a plurality of magnetic impedance elements which are disposed at opposite sides of an electric wire through which a current to be detected is flowing so that each magnetic impedance element generates a voltage corresponding to the intensity of a magnetic field generated around the electric wire; a driving unit for supplying a current to the plurality of magnetic impedance elements thereby driving the plurality of magnetic impedance elements; a calculation unit for determining the value of the current flowing through the electric wire from voltages generated across the plurality of magnetic impedance elements; and a guide for guiding the electric wire, wherein the electric wire is guided such that it is located at the midpoint between the plurality of magnetic impedance elements disposed at opposite sides.

In this current sensor according to the present invention, the electric wire carrying the current to be detected is supported in a stable fashion by the guide so that the electric wire is located at the midpoint between the magnetic impedance elements disposed at opposite sides. This makes it possible to detect the current flowing through the electric wire in a highly reliable fashion, and improved workability can be achieved.

BRIEF DESCRIPTION OF THE DRAWINGS

Fig. 1 is a schematic diagram illustrating an embodiment of a current sensor according to the present invention;
Fig. 2 is a schematic diagram illustrating another embodiment of a current sensor according to the present invention;
Fig. 3 is a schematic diagram illustrating another embodiment of a current sensor according to the present invention;
Fig. 4 is a schematic diagram illustrating another embodiment of a current sensor according to the present invention;
Fig. 5 is a schematic diagram illustrating an effect of a change in the distance between magnetic impedance elements and an electric wire through which a current to be detected is flowing;
Fig. 6 is a schematic diagram illustrating an effect of an external magnetic field;
Fig. 7 is a schematic diagram illustrating an effect of an external magnetic field;
Fig. 8 is a cross-sectional view illustrating another embodiment of a current sensor according to the present invention;
Fig. 9 is a perspective view of the current sensor shown in Fig. 8;
Fig. 10 is a perspective view illustrating another embodiment of a current sensor according to the present invention;
Fig. 11 is a schematic diagram illustrating a current sensor mounted on a clip;

Fig. 12 is a cross-sectional view illustrating another embodiment of a current sensor according to the present invention;

Fig. 13 is a cross-sectional view illustrating another embodiment of a current sensor according to the present invention;

Fig. 14 is a cross-sectional view illustrating another embodiment of a current sensor according to the present invention;

Fig. 15 is a cross-sectional view illustrating another embodiment of a current sensor according to the present invention;

Fig. 16 is a plan view illustrating another embodiment of a current sensor according to the present invention;

Fig. 17 is a side view of the current sensor shown in Fig. 16;

Fig. 18 is a schematic diagram illustrating a guide;

Fig. 19 is a schematic diagram illustrating techniques of applying a magnetic bias to a magnetic impedance element;

Fig. 20 is a circuit diagram illustrating an example of a circuit configuration;

Fig. 21 is a circuit diagram illustrating another example of a circuit configuration;

Fig. 22 is a circuit diagram illustrating another example of a circuit configuration;

Fig. 23 is a circuit diagram illustrating another example of a circuit configuration; and

Fig. 24 is a graph illustrating a characteristic of a magnetic impedance element.

## DESCRIPTION OF THE PREFERRED EMBODIMENTS

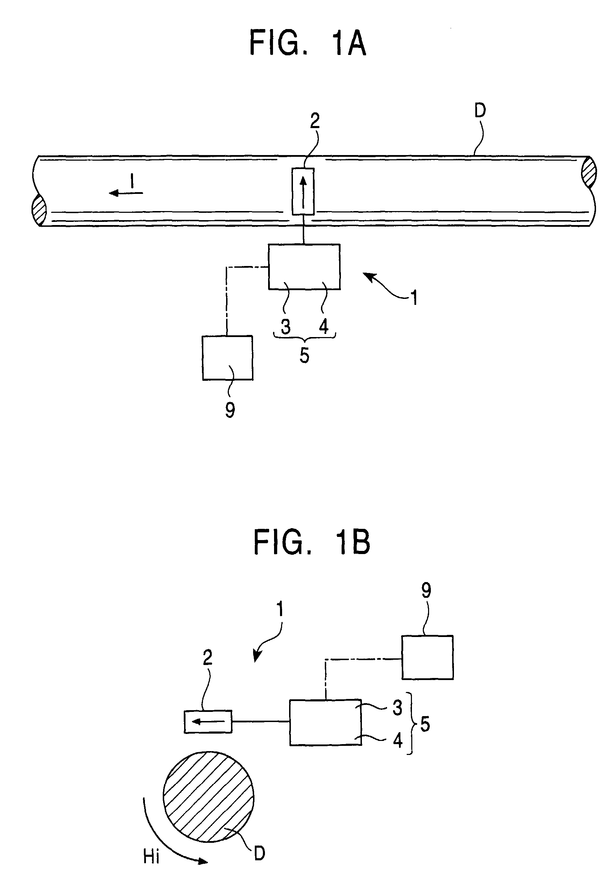

A first embodiment of a current sensor 1 according to the present invention is described below with reference to Fig. 1. As shown in Fig. 1, the current sensor 1 includes a magnetic impedance element 2 serving as a detector element, a circuit unit 5 including a driving circuit (driving unit) 3 for driving the magnetic impedance element 2 and also including an amplifier 4, and a calculation unit 9 to which the output of the circuit unit 5 is applied. The magnetic impedance element 2 is disposed at a location a predetermined small distance apart from the exterior circumferential surface of an electric wire D through which a current to be detected is flowing.

A current I is passed through the electric wire D in a direction from right to left in Fig. 1A. A magnetic field Hi with an intensity corresponding to the magnitude of the current I is generated around the electric wire D in a counterclockwise direction in Fig. 1B.

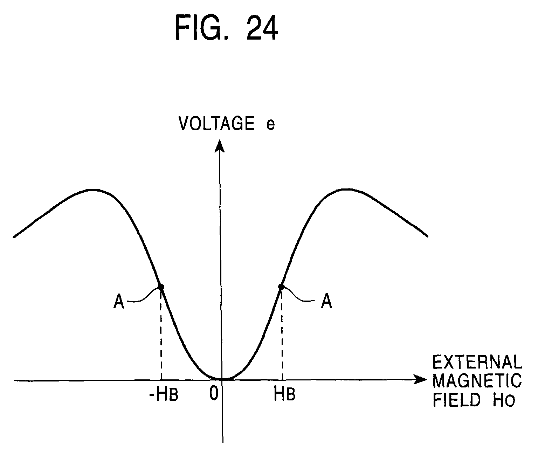

The magnetic impedance element 2 is formed in a stripe shape using an amorphous alloy such as a CoSiB-based alloy, FeCoSiB-based alloy, etc. The magnetic impedance element 2 has an external magnetic filed Ho versus voltage e characteristic such as that shown in Fig. 24 when a high-frequency current i is passed through the magnetic impedance element 2.

More specifically, when the external magnetic field Ho is positive, the voltage e across the magnetic impedance element 2 first increases and then decreases with the magnitude of the positive external magnetic field Ho in a longitudinal direction of the magnetic impedance element 2. Similarly, when the external magnetic field Ho is negative, the voltage e across the magnetic impedance element 2 first increases and then decreases with the magnitude of the external magnetic field Ho. That is, the external magnetic filed Ho versus voltage e characteristic of the magnetic impedance element 2 is symmetric about the sign of the external magnetic field Ho, and thus a voltage e corresponding to a given external magnetic field Ho is obtained across the magnetic impedance element 2. Herein, the direction of the magnetic impedance element 2 is defined such that when an external magnetic field is applied in a direction denoted by an arrow in the figure, the magnetic impedance element 2 assumes that the external magnetic field is positive. This direction is also referred to as a sensitivity direction.

The magnetic impedance element 2 having a sensitivity characteristic such as that described above is disposed such that the sensitivity direction becomes perpendicular to the direction of the current I flowing through the electric wire D. More specifically, the magnetic impedance element 2 is disposed such that the sensitivity direction of the magnetic impedance element 2 denoted by the arrow in Fig. 1 becomes parallel to a tangent line of the magnetic filed Hi generated in the form of an annular ring so that the magnetic impedance element 2 can detect the intensity of the magnetic field Hi which varies depending on the magnitude of the current I, regardless of the direction of the current I flowing through the electric wire D.

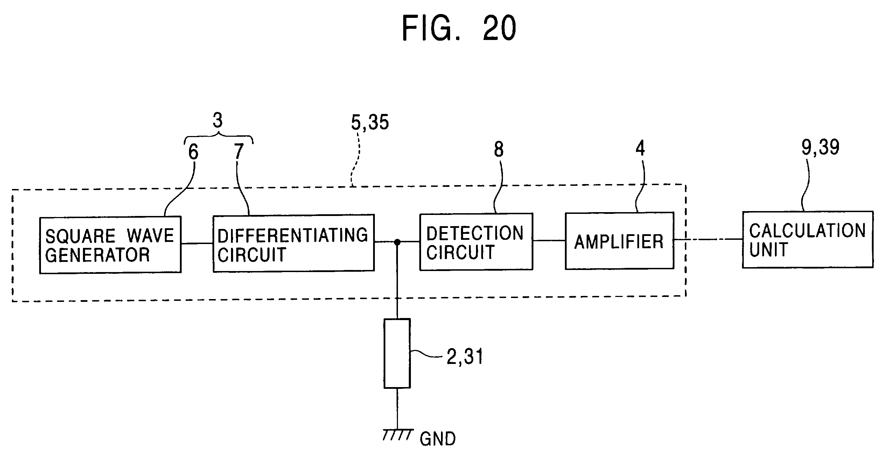

As shown in Fig. 20, the circuit unit 5 includes a driving circuit 3 including a square wave generator 6 and a differentiating circuit 7 to which a current generated by the square wave generator 6 is applied, a detection circuit 8 for detecting the output of the magnetic impedance element 2, and an amplifier 4 connected to the detection circuit 8. The output of the amplifier 4 is input to the calculation unit 9. The magnetic impedance element 2 is driven by the current supplied from the square wave generator 6 via the differentiating circuit 7.

The voltage e generated by the magnetic impedance element 2 in response to the magnetic field Hi applied thereto is input to the calculation unit 9 via the detection circuit 8 and the amplifier 4. A table or a calculation function representing the voltage e generated across the magnetic impedance element 2 as a function of the external magnetic field Ho (magnetic field Hi in this specific example) with an intensity corresponding to the current I flowing through the electric wire D, such as that shown in Fig. 24, is stored in advance in the calculation unit 9. Using this table or calculation function, the calculation unit 9 calculates the value of the current I flowing through the electric wire D from the voltage e generated across the magnetic impedance element 2.

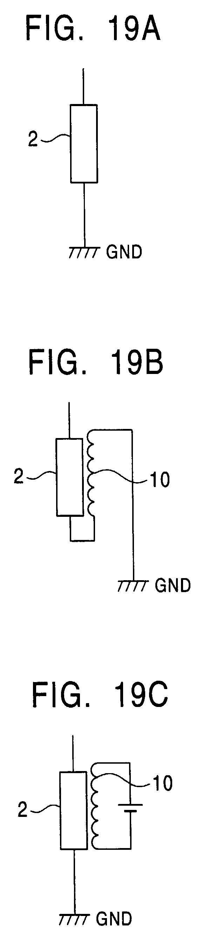

A magnetic bias field HB may be applied to the magnetic impedance element 2 thereby determining the operating point of the magnetic impedance element 2. That is, a magnetic bias field HB may or may not be applied to the magnetic impedance element 2. Fig. 19A illustrates an example in which a magnetic bias filed HB is applied to the magnetic impedance element 2, and Figs. 19B and 19C illustrates examples in which a magnetic bias coil 10 is disposed in the vicinity of the magnetic impedance element 2 so that a magnetic bias field HB is applied to the magnetic impedance element 2.

In the example shown in Fig. 19B, a downstream part of the magnetic impedance element 2 is employed as a magnetic bias coil 10 and disposed on a side of the magnetic impedance element 2 thereby applying a self magnetic bias field HB to the magnetic impedance element 2. In the example shown in Fig. 19C, a separate magnetic bias coil 10 is disposed on a side of the magnetic impedance element 2 thereby applying a DC magnetic bias field HB. Either magnetic bias technique may be employed to determine the operating point A of the magnetic impedance element 2 (refer to Fig. 24).

The operation of the current sensor 1 constructed in the above-described fashion is described below. In Fig. 1A, the magnetic impedance element 2 is disposed at a location predetermined small distance apart from the electric wire D through which a current I is passed in a direction from right to left in the figure. Herein, a magnetic field Hi with an intensity corresponding to the magnitude of the current I is generated around the electric wire D. The orientation of the magnetic impedance element 2 is set such that the sensitivity direction of the magnetic impedance element 2 becomes parallel to the direction of the magnetic field Hi.

The magnetic impedance element 2 is driven by a current supplied from the driving circuit 3, and a voltage e corresponding to the intensity of the magnetic field Hi is generated across the magnetic impedance element 2. The voltage e is input to the amplifier 4 via the detection circuit 8. The output of the amplifier is then applied to the calculation unit 9. From the value received from the amplifier 4, the calculation unit 9 determines the value of the current I flowing through the electric wire D using the table or the calculation function described above. The resultant value of the current I is output from the calculation unit 9.

As described above, because the magnetic impedance element 2 has a high sensitivity and a high-speed response characteristic, it is possible to detect a current over a wide range of magnitude including a very small current at a high speed in a highly reliable fashion without having to dispose an additional magnetic circuit which is required in the conventional magnetic sensors (such as an MR device and a Hall device). Because the magnetic impedance element 2 is based on the capability of magnetoelectric conversion, high-sensitivity detection is also possible for a DC current I flowing through the electric wire D.

The magnetic impedance element 2 has a wide frequency response characteristic which allows detection of a magnetic field over a wide frequency range from DC to several MHz. Thus, the magnetic impedance element 2 also has a high sensitivity to AC currents at high frequencies. Because the current I flowing through the electric wire D can be detected in a non-contact manner, the detection of the current I becomes easy. This results in an improvement in workability in detection of the current I.

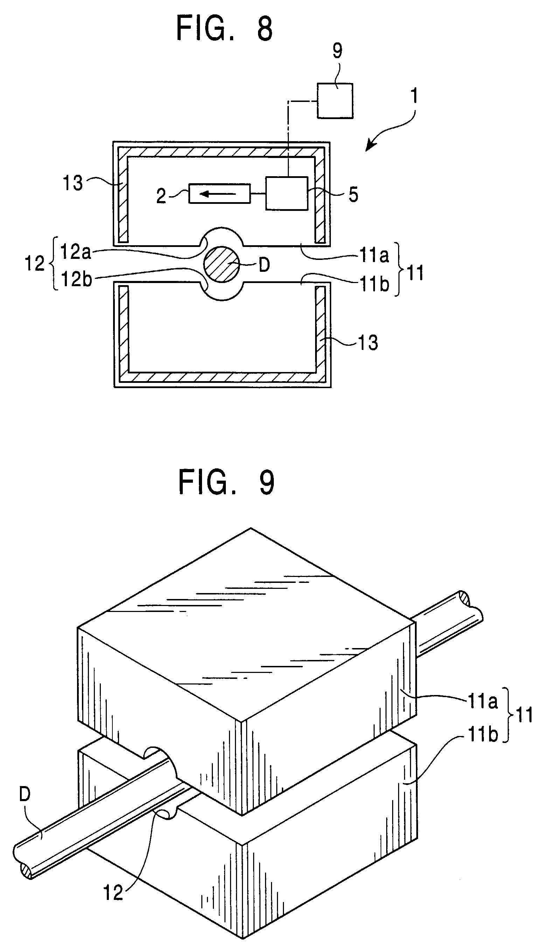

Figs. 8 and 9 illustrate specific examples of manners in which the first embodiment described above is practiced. In an example shown in Fig. 8, the current sensor 1 comprises a case 11 made of a non-magnetic material, a magnetic impedance element 2 disposed in the case 11, and a circuit unit 5 firmly disposed in the case 11.

The case 11 is made up of two separable components, an upper member 11a and a lower member 11b, which are connected to each other into a single form. The members 11a and 11b have semi-circular cut-outs 12a and 12b, respectively. When the two members 11a and 11b are connected to each other, the semi-circular cut-outs 12a and 12b form a through-hole serving as an electric wire holder 12 in a connection plane. The electric wire holder 12 has a diameter substantially equal to the diameter of the electric wire D carrying a current to be detected so that the electric wire D is firmly held in the case 11.

A magnetic shied 13 is disposed along the perimeter of the case 11 such that the electric wire D, the magnetic impedance element 2, and the circuit unit 5 connected to the calculation unit 9 are surrounded by the magnetic shield 13. Thus, when the upper and lower members 11a and 11b of the case 11 are connected together into the single form, an external magnetic field is blocked, thereby preventing the magnetic impedance element 2 and the circuit unit 5 from being disturbed by the external magnetic field.

When the current I flowing through the electric wire D is detected using the current sensor 1 constructed in the above-described manner, the electric wire D is fist fitted into the semi-circular cut-out 12a (12b) of either member 11a (11b) of the case 11, and the other member is then fitted to the first member so that the electric wire D carrying the current to be detected is held in the case 11 into a state which allows the current I to be detected.

The magnetic field Hi generated around the electric wire D is applied to the magnetic impedance element 2 through the case 11 and detected by the magnetic impedance element 2. Herein, because the case 11 is made of a non-magnetic material, the magnetic impedance element 2 precisely detects the magnetic field Hi. Furthermore, because the magnetic impedance element 2 is disposed such that its orientation becomes perpendicular to the direction of the current I flowing through the electric wire D, the sensitivity direction of the magnetic impedance element 2 becomes parallel to the direction of the magnetic field Hi generated around the electric wire D thereby allowing the magnetic field Hi to be detected in a highly reliable fashion.

As described above, because the magnetic impedance element 2 and the circuit unit 5 are disposed in the case 11, handling becomes easy and workability is improved. Furthermore, because the electric wire D carrying the current to be detected is firmly held by the electric wire holder 12 such that the magnetic impedance element 2 is located at a fixed distance from the electric wire D, the current I can be detected in a highly reliable fashion.

Furthermore, the mechanical shield 13 disposed along the perimeter of the case 11 blocks an external magnetic field which would otherwise cause a disturbance, thereby ensuring that the magnetic field Hi generated around the electric wire D can be precisely detected in a highly reliable fashion.

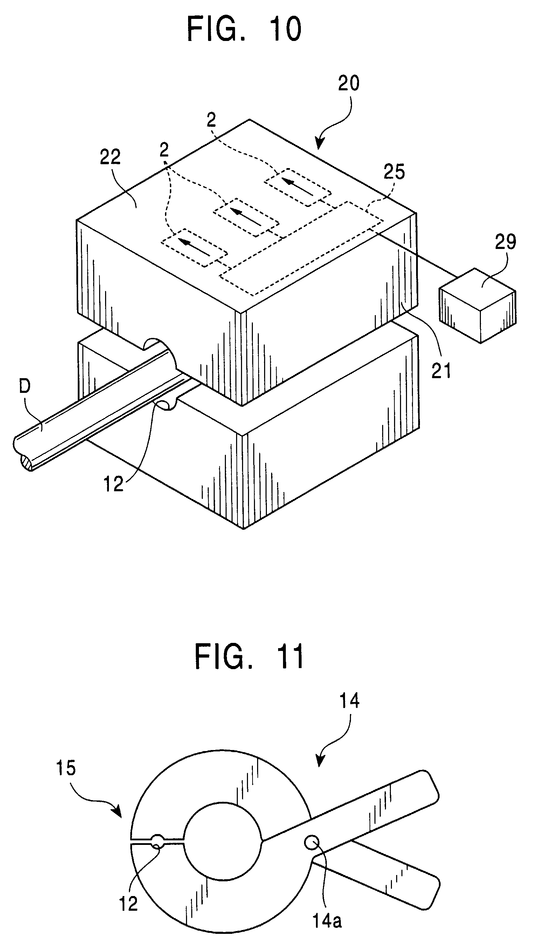

The specific embodiment described above may be applied to tips of a clip 14 as shown in Fig. 11. More specifically, in Fig. 11, the clip 14 has tips 15 which can be opened and closed as required by means of a hinge 14a. The magnetic impedance element 2 and the circuit unit 5 may be disposed in either tip 15. When a current I flowing through an electric wire D is detected, the electric wire D is held by the electric wire holder 12 shown in Fig. 11. This make is possible to easily detect the current I.

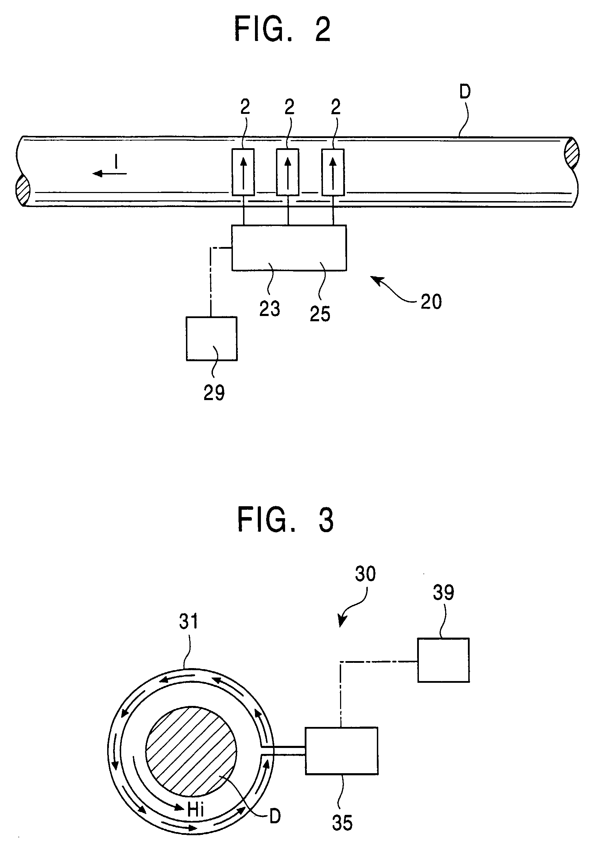

A second embodiment of the present invention is described with reference to Fig. 2.

In Fig. 2, a current sensor 20 includes a plurality of magnetic impedance elements 2, a circuit unit 25 including a driving circuit (driving unit) 23 for driving the plurality of magnetic impedance elements 2, and a calculation unit 29 to which the output of the circuit unit 25 is applied. The respective magnetic impedance elements 2 are disposed at particular distances from the exterior circumferential surface of an electric wire D through which a current to be detected is flowing, such that the sensitivity direction of each magnetic impedance element 2 becomes perpendicular to the direction of the current I flowing through the electric wire D. Herein, the magnetic impedance elements 2 are disposed such that the sensitivity directions thereof become parallel to each other and oriented in the same direction.

The current I is passed through the electric wire D in a direction from right to left in Fig. 2, and a magnetic field Hi with an intensity corresponding to the magnitude of the current I is generated around the electric wire D.

tric wire D.

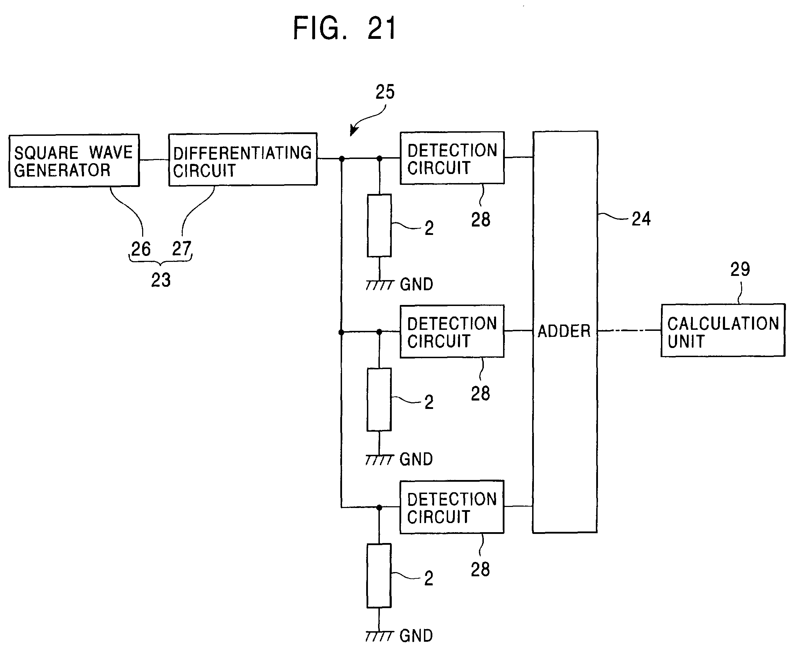

As shown in Fig. 21, the circuit unit 25 includes the driving circuit 23 including a square wave generator 26 and a differentiating circuit 27. A current generated by the squared wave generator 26 is supplied in parallel to the magnetic impedance elements 2 via the differentiating circuit 27. Thus, the plurality of magnetic impedance elements 2 are driven by the driving circuit 23.

Voltages e generated across the respective magnetic impedance elements 2 are input to an adder 24 via detection circuits 28 connected to the respective magnetic impedance elements 2. The adder 24 is connected to the calculation unit 29 so that the output signal of the adder 24, which represents the sum of the voltages e of the magnetic impedance elements 2, is supplied to the calculation unit 29. Data representing the number of magnetic impedance elements 2 and a table or a calculation function representing the voltage e generated across the magnetic impedance element 2 as a function of the external magnetic field Ho (magnetic field Hi in this specific example) with an intensity corresponding to the current I flowing through the electric wire D are stored in advance in the calculation unit 29. Using this table or calculation function, the calculation unit 29 calculates the value of the current I flowing through the electric wire D from the voltages e generated across the respective magnetic impedance elements 2.

The operation of the current sensor 20 constructed in the above-described fashion is described below. The plurality of magnetic impedance elements 2 are disposed small predetermined distances apart from the electric wire D through which a current is passed from right to left in Fig. 2 wherein a magnetic field Hi is generated around the electric wire D. The orientation of each magnetic impedance element 2 is set such that the sensitivity direction of the magnetic impedance element 2 becomes parallel to the direction of the magnetic field Hi generated around the electric wire D through which a current to be detected is flowing.

Each magnetic impedance element 2 generates a voltage e corresponding to the intensity of magnetic field Hi, and the voltage e is input to the adder 24 via the corresponding detection circuit 28. From the value output from the adder 24, the calculation unit 9 determines the value of the current I flowing through the electric wire D using the table or the calculation function described above. The resultant value of the current I is output from the calculation unit 9.

Thus, as described above, by employing the plurality of magnetic impedance elements 2 disposed such that the sensitivity directions thereof become parallel to each other, the sum of voltages e generated by the respective magnetic impedance elements 2 is detected, and the current I flowing through the electric wire D is calculated by the calculation unit 29. The employment of the plurality of magnetic impedance elements 2 makes it possible for the current sensor 20 to have a high enough sensitivity to detect the current I with a very small magnitude.

Fig. 10 illustrates a specific example of a manner in which the second embodiment described above is practiced. In Fig. 10, the current sensor 20 comprises, as in the first embodiment, a case 21 including two separable members made of a non-magnetic material, magnetic impedance elements 2 disposed in the case 21, a circuit unit 25 firmly disposed in the case 21, and a calculation unit 29 to which the output of the circuit unit 25 is applied. When the two case members are connected to each other, a through-hole serving as an electric wire holder 12 is formed.

A magnetic shied 22 is disposed along the perimeter of the case 21 such that the electric wire D, the magnetic impedance elements 2, and the circuit unit 25 are surrounded by the magnetic shield 22 thereby ensuring that an external magnetic field is blocked and thus preventing the magnetic impedance elements 2 and the circuit unit 25 from being disturbed by the external magnetic field.

In this specific embodiment, because the plurality of magnetic impedance elements 2 are disposed together with the circuit unit 25 in the case 21, it is possible to detect the current I flowing through the electric wire D even when the magnitude of the current I is very small, by determining the sum of outputs of the respective magnetic impedance elements 2. Furthermore, in the operation of detecting the current I, the current sensor 20 can be easily handled, and thus workability is improved. Furthermore, because the electric wire D carrying the current to be detected is firmly held by the electric wire holder 12 such that the magnetic impedance elements 2 are located at fixed distances from the electric wire D and such that an external magnetic field which can cause a disturbance is blocked, the current I can be detected in a highly reliable fashion.

The second embodiment may also be applied to tips 15 of a clip 14 such as that shown in Fig. 11. In this case, when a current I flowing through an electric wire D is detected, the electric wire D is pinched by an electric wire holder 12 shown in Fig. 11. This make is possible to easily detect the current I.

A third embodiment of the present invention is described below with reference to Fig. 3. As shown in Fig. 3, a current sensor 30 includes a magnetic impedance element 31 formed in an annular ring shape, a circuit unit 35 including a driving circuit (driving unit) for driving the magnetic impedance element 31, and a calculation unit 39 to which the output of the circuit unit 35 is applied.

The ring-shaped magnetic impedance element 31 is disposed in such a manner as to surround an electric wire D carrying a current to be detected. As a result, the sensitivity direction of the magnetic impedance element 31 is disposed along a magnetic field Hi generated around the electric wire D.

A circuit similar to that shown in Fig. 20 may be employed as the circuit unit 35. That is, the circuit unit 35 includes a driving circuit 3 including a square wave generator 6 and a differentiating circuit 7, a detection circuit 8, and an amplifier 4. The magnetic impedance element 2 is driven by a current supplied from the square wave generator 6 via the differentiating circuit 7.

A voltage e generated by the magnetic impedance element 31 is input to the amplifier 4 via the detection circuit 8. The output of the amplifier is then applied to a calculation unit 39. The calculation unit 39 includes a table or a calculation function which has been stored in advance and which represents the voltage e generated by the magnetic impedance element 31 as a function of the external magnetic field Ho (magnetic field Hi in this specific example) with an intensity corresponding to the current I flowing through the electric wire D. Using this table or calculation function, the calculation unit 39 calculates the value of the current I flowing through the electric wire D from the voltage e generated by the magnetic impedance element 31.

When the current I flowing through the electric wire D is detected using the current sensor 30 constructed in the above-described manner, the electric wire D is inserted into the ring of the magnetic impedance element 31. Herein, the sensitivity direction of the magnetic impedance element 31 always becomes parallel to the tangent line of the magnetic field Hi generated around the electric wire D.

A voltage e is generated by the magnetic impedance element 31 in response to the magnetic field Hi applied thereto. The voltage e is input to the calculation unit 39 via the detection circuit 8 and the amplifier 4. From the value of the voltage e, the calculation unit 39 determines the value of the current I flowing through the electric wire D using the table or the calculation function described above. The resultant value of the current I is output from the calculation unit 39.

In this embodiment, as described above, the magnetic impedance element 31 formed in the annular ring shape is disposed so as to surround an electric wire D through which a current to be detected is flowing, so that the sensitivity direction of the magnetic impedance element 31 always becomes parallel to the direction of the magnetic field Hi thereby ensuring that the current sensor 30 can perform high-sensitivity detection of the current.

Furthermore, because the electric wire D carrying the current to be detected is placed such that it extends through the annular ring of the magnetic impedance element 31, the current I can be precisely detected even when a fluctuation of the distance between the magnetic impedance element 31 and the electric wire D occurs during detection owing to a vibration or movement or the like of the electric wire D. In this case, the calculation unit 39 determines the integral of the signal output from the circuit unit 35 so as to compensate for the fluctuation of the distance.

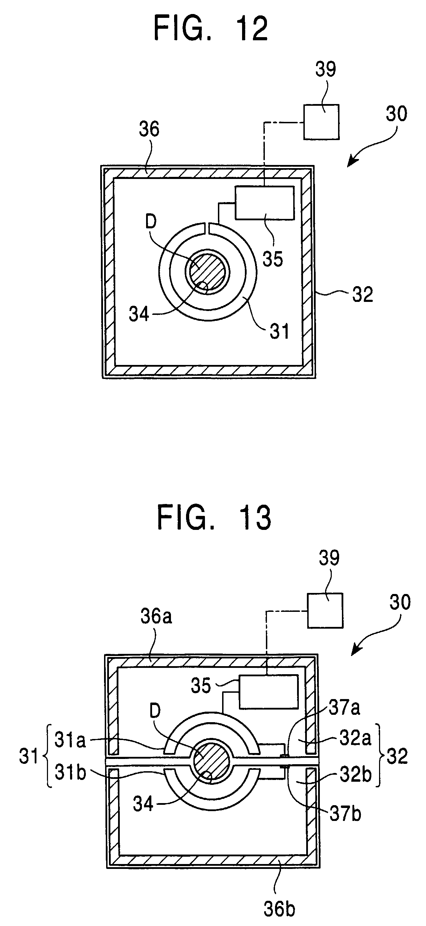

Figs. 12 and 13 illustrate specific examples of manners in which the third embodiment described above is practiced. In an example shown in Fig. 12, the current sensor 30 includes a case 32 made of a non-magnetic material, a magnetic impedance element 31 in the form of a single-turn annular ring disposed in the case 32, a circuit unit 35 connected to a calculation unit 39 firmly disposed in the case 32, and an electric wire holder 34 in the shape of a through-hole formed in the annular ring of the magnetic impedance element 31. An electric wire D carrying a current to be detected is inserted through the electric wire holder 34. A magnetic shield 36 is disposed along the perimeter of the case 32 so as to prevent the magnetic impedance element 31 and the circuit unit 35 from being disturbed by an external magnetic field.

Alternatively, as shown in Fig. 13, the current sensor 30 may include a case 32 made up of two members 32a and 32b separable from each other, and semicircular-shaped magnetic impedance elements 31a and 31b disposed in the respective members 32a and 32b. In this case, magnetic shields 36a and 36b which are C-shaped in cross section are disposed along the perimeter of the respective members 32a and 32b. In one member 32a, there is disposed a circuit unit 35 connected to the magnetic impedance element 31a and also connected to a calculation unit 39. Electrodes 37a and 37b connected to the respective magnetic impedance elements 31a and 31b are disposed in connection boundary planes of the respective members 32a and 32b such that they are exposed to the outside. The electrodes 37a and 37b are electrically connected to each other when the two members 32a and 32b are combined together. When the two members 32a and 32b are combined together, an electric wire holder 34 is formed. A current I flowing through an electric wire D held by the electric wire holder 34 is detected by the magnetic impedance element 31 in the form of an annular ring having a high sensitivity.

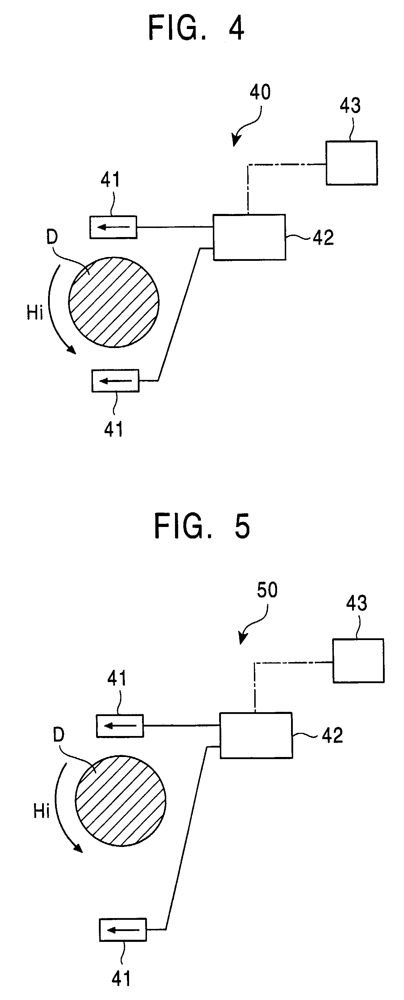

A fourth embodiment of the present invention is described below with reference to Figs. 4 and 5. As shown in Fig. 4, a current sensor 40 includes two magnetic impedance elements 41 and 41 which are disposed at opposite sides of an electric wire D carrying a current to be detected, a circuit unit 42 including a driving circuit (driving unit) for driving the magnetic impedance elements 41, and a calculation unit 43 for determining the value of the current I flowing through the electric wire D from voltages e generated across the two magnetic impedance elements 41. The magnetic impedance elements 41 are disposed such that the distances from the electric wire D to the respective magnetic impedance elements 41 become equal to each other.

In a specific embodiment shown in Fig. 5, a magnetic sensor 50 also includes two magnetic impedance elements 41 and 41 which are disposed at opposite sides of an electric wire D carrying a current to be detected. However, in this case, they are disposed such that the distances from the electric wire D to the respective magnetic impedance elements 41 become different from each other.

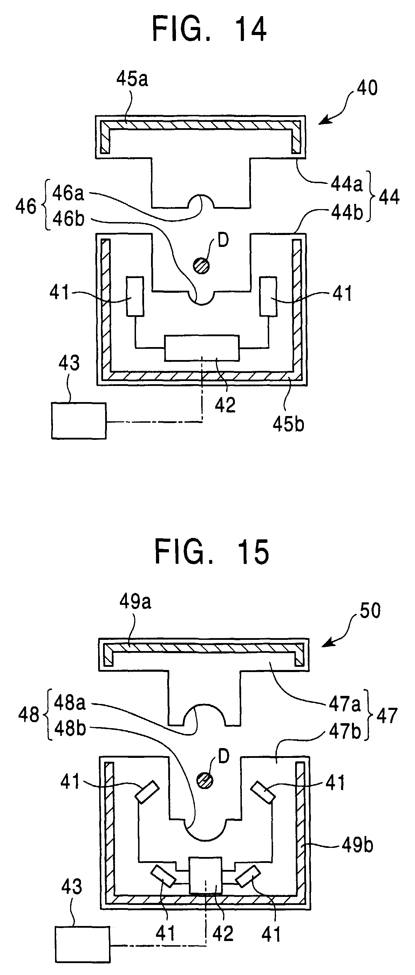

Figs. 14 and 15 illustrate specific examples of manners in which the current sensors 40 and 50 are realized. In an example shown in Fig. 14, a current sensor 40 includes a case 44 made of a non-magnetic material and a calculation unit 43. The case 44 is made up of a first member 44a and a second member 44b. The first member 44a has a protrusion extending downward. A magnetic shield 45a which is C-shaped in cross section is disposed along the perimeter of the first member 44a. A semi-circular cut-out 46a is formed in the end face of the protrusion. The second member 44b is formed in the shape of a recess in cross section. A semi-circular cut-out 46b is formed in the bottom face of the recession. A magnetic shield 45b which is C-shaped in cross section is disposed along the perimeter of the second member 44b. In the second member 44b, a circuit unit 42 is disposed at the center below the recess. Furthermore, in the second member 44b, two magnetic impedance elements 41 connected to the circuit unit 42 are firmly disposed equally apart from the semi-circular cut-out 46b at opposite sides of the semi-circular cut-out 46b.

The protrusion of the first member 44a is designed to fit in the recess of the second member 44b. When the two members 44a and 44b are combined together into a single form, the semi-circular cut-outs 46a and 46b are combined together to form an electric wire holder 46. The resultant electric wire holder 46 has a diameter substantially equal to the diameter of an electric wire D held thereby. When the electric wire D is held by the electric wire holder 46, the electric wire is held in the case 44 at a location equally apart from the two magnetic impedance elements 41.

As a result, a current I flowing through the electric wire D can be detected in a highly reliable fashion without causing a change in the distance between the electric wire D and the respective magnetic impedance elements 41.

In an example shown in Fig. 15, a current sensor 50 includes a case 47 formed of a non-magnetic material which is separable into a first member 47a and a second member 47b. The first member 47a has a protrusion extending downward. A large semi-circular cut-out 48a is formed in the end face of the protrusion. The second member 47b is formed in the shape of a recess in cross section. A large semi-circular cut-out 48b is formed in the bottom face of the recession.

A circuit unit 42 connected to a calculation unit 43 is disposed in the central part of the second member 47b. Furthermore, in the second member 47b, a plurality of magnetic impedance elements 41 connected to the circuit unit 42 are disposed on the right and left sides in a symmetric fashion. Magnetic shields 49a and 49b are disposed along the perimeters of the first and second members 47a and 47b, respectively. When the projection of the first member 47a is fit into the recess of the second member 47b, the semi-circular cut-outs 48a and 48b are combined together to form an electric wire holder 48. Because the resultant electric wire holder 48 has a large diameter, an electric wire D with a large diameter can be held.

The four magnetic impedance elements 41 are located such that two magnetic impedance elements 41 are located on one side of the electric wire holder 48 and the remaining two magnetic impedance elements 41 are located on the opposite side.

The calculation unit 43 has a capability of correcting a detection error due to fluctuations of distances from the electric wire D to the respective magnetic impedance elements 41. Therefore, even if the electric wire D carrying a current to be detected moves in the electric wire holder 48 and, as a result, the distances with respect to the magnetic impedance elements 41 are fluctuated, the calculation unit 43 determines a precise value of the current.

In this specific embodiment, because the plurality of magnetic impedance elements 41 are disposed as described above, it is possible to detect the current I flowing through the electric wire D in a highly reliable fashion even if the magnitude of the current I is very small. Furthermore, because the magnetic impedance elements 41 are disposed on opposite sides of the electric wire D in a symmetric fashion, a detection error due to fluctuations of the distances of the magnetic impedance elements 41 from the electric wire D can be corrected by processing the outputs of the respective magnetic impedance elements 41 using the calculation unit 43. This allows precise detection of the current.

Furthermore, because a detection error due to the fluctuations of the distances of the magnetic impedance elements 41 from the electric wire D can be corrected, the current sensor 50 having the electric wire holder 48 with the large diameter can precisely detect the current I flowing through an electric wire D having a small diameter. Although the electric wire D having the small diameter can move in the electric wire holder having the large diameter, the variations in the distances of the magnetic impedance elements 41 from the electric wire D is compensated for by the calculation unit 43, and thus the current I can be detected in a highly reliable fashion. Thus, the single current sensor 50 can be used for electric wires D having various diameters.

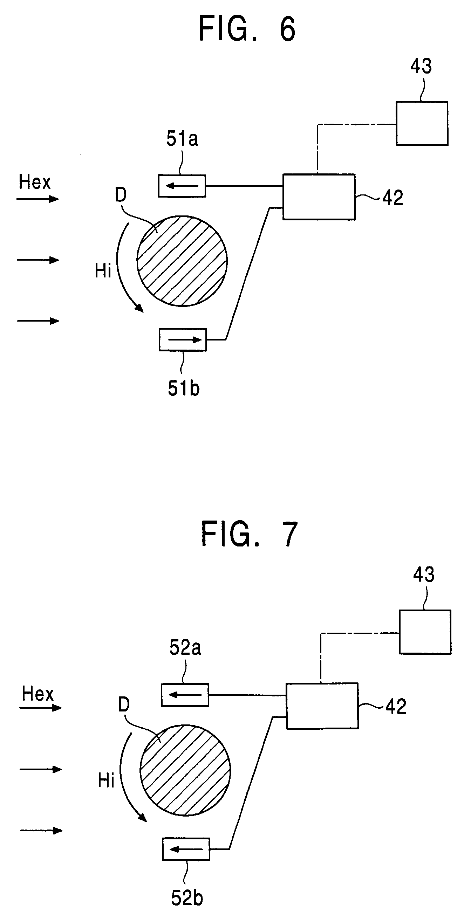

When the plurality of magnetic impedance elements are disposed such that they are located at opposite sides of the electric wire D and such that the sensitivity directions thereof become parallel to each other, it is possible to cancel a uniform external magnetic field applied to the electric wire D and also to the magnetic impedance elements, as described below with reference to Figs. 6 and 7.

Herein, we assume that two magnetic impedance elements 51a and 51b are disposed, as shown in Fig. 6, at opposite sides of an electric wire D carrying a current to be detected such that the sensitivity directions thereof become parallel to each other but the sensitivity directions are opposite to each other.

Furthermore, we assume that a magnetic field Hi is generated in a counterclockwise direction in Fig. 6 around the electric wire D through which the current to be detected is flowing, and that the magnetic field Hi is applied to the respective magnetic impedance elements 51a and 51b. Because the orientations of the magnetic impedance elements 51a and 51b become parallel to the tangent line of the magnetic field Hi, the magnetic field Hi is detected by the magnetic impedance elements 51a and 51b.

We further assume that a disturbing external magnetic field Hex is uniformly applied, from left to right in Fig. 6, to the magnetic impedance elements 51a and 51b. Because the magnetic impedance elements 51a and 51b are disposed such that the magnetic impedance element 51a has a positive sensitivity in a right-to-left direction and the magnetic impedance element 51b has a positive sensitivity in a left-to-right direction, the disturbing external magnetic field Hex is negatively applied to the magnetic impedance element 51a and positively to the magnetic impedance element 51b. Thus, the overall magnetic filed Ha applied to the magnetic impedance element 51a is given by:

$$Ha = Hi - Hex \qquad (1)$$

On the other hand, the overall magnetic filed Hb applied to the magnetic impedance element 51b is given by:

$$Hb = Hi + Hex \qquad (2)$$

If the outputs of the two magnetic impedance elements 51a and 51b are added together, then the resultant magnetic field Hab is given by:

$$Hab = Ha + Hb = 2Hi \qquad (3)$$

Thus, the external magnetic field Hex is cancelled in Hab, and a voltage e precisely corresponding to the magnetic field Hi is generated and applied to the calculation unit 43 via the circuit unit 42.

In the case where magnetic impedance elements 52a and 52b are disposed such that they have a positive sensitivity in the same direction and such that the sensitivity directions thereof are parallel to each other, the overall magnetic field Ha applied to the magnetic impedance element 52a is given by the sum of a magnetic field Hi generated by an electric wire D and applied in a positive direction to the magnetic impedance element 52a and a disturbing external magnetic field Hex applied in a negative direction. Thus

$$Ha = Hi - Hex \qquad (4)$$

On the other hand, the overall magnetic field Hb applied to the magnetic impedance element 52b is given by the sum of a magnetic field Hi generated by the electric wire D and applied in a negative direction to the magnetic impedance element 52b and a disturbing external magnetic field Hex applied in a negative direction. Thus

$$Hb = -Hi - Hex \qquad (5)$$

If the outputs of these magnetic impedance elements 52a and 52b are subtracted, then

$$Hab = Ha - Hb = 2Hi \qquad (6)$$

Also in this case, the term of the disturbing external magnetic field Hex is cancelled in the resultant magnetic field Hab, and thus a voltage e precisely representing the intrinsic magnetic field Hi is applied to the calculation unit 43 via the circuit unit 42.

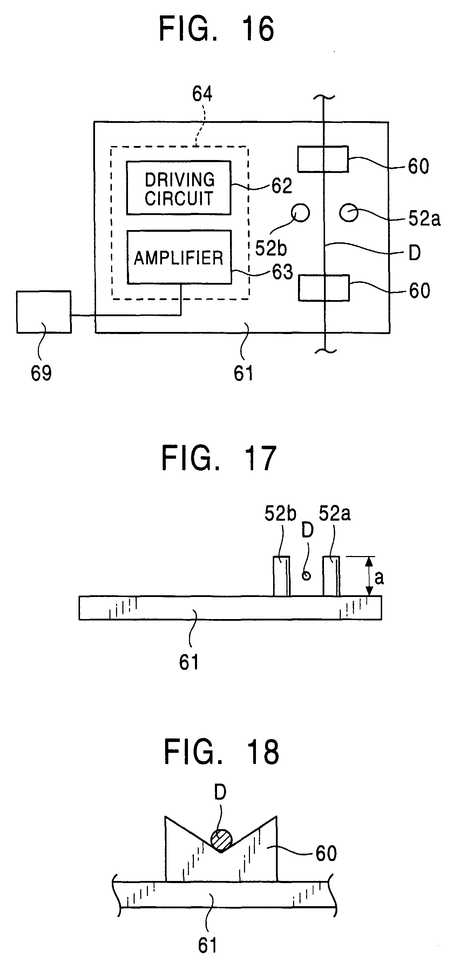

In addition to the manner shown in Fig. 14, the current sensors 40 and 50 may also be realized in manners as shown in Figs. 16, 17, and 18. In the example shown in Fig. 16, magnetic impedance elements 52a and 52b are disposed on a base plate 61 at opposite sides of an electric wire D supported by guides 60 such that the magnetic impedance elements 52a and 52b have a positive sensitivity in the same direction and such that the sensitivity directions thereof become parallel to each other.

Each guide 60 has a V-shaped groove as shown in Fig. 18 so that the electric wire D is held in the V-shaped groove. The locations of the guides 60 and the depth of the V-shaped grooves are adjusted so that the electric wire D is located at an optimum position at the midpoint between the magnetic impedance elements 52a and 52b with a height a. A uniform disturbing external magnetic field Hex is applied to the electric wire D.

On the base plate 61, there are disposed a driving circuit (driving unit) 62 for driving the magnetic impedance elements 52a and 52b and a circuit unit 64 including an amplifier 63 to which the voltages e generated by the magnetic impedance elements 52a and 52b are applied. A signal output from the circuit unit 64 is applied to the calculation unit 69.

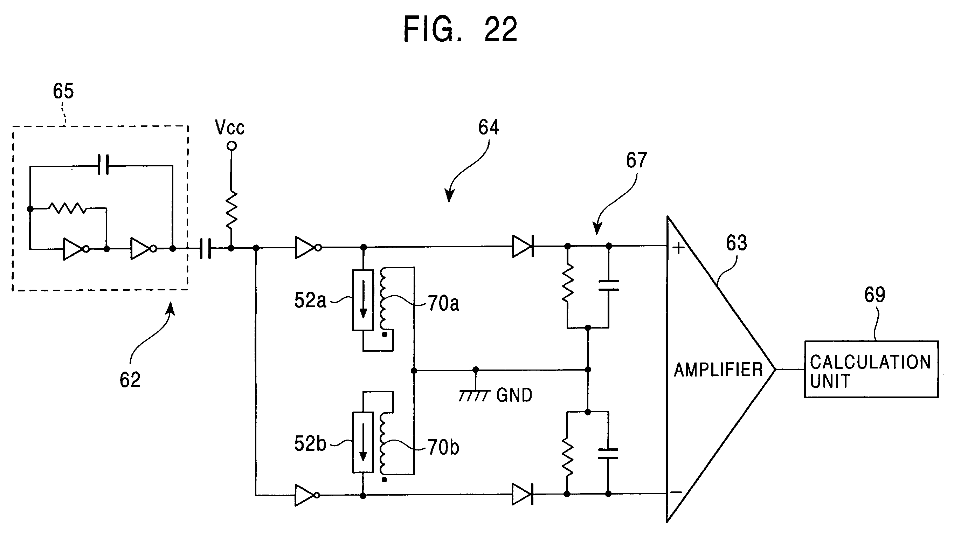

As shown in Fig. 22, the circuit unit 64 includes a driving circuit 62 including an oscillator 65 for supplying a driving current through the magnetic impedance elements 52a and 52b, a rectifying circuit 67 to which the outputs of the respective magnetic impedance elements 52a and 52b are applied, and an amplifier 63 connected to the rectifying circuit 67. The output of the amplifier 63 is applied to the calculation unit 69.

Magnetic bias coils 70a and 70b are disposed on sides of the magnetic impedance elements 52a and 52b, respectively, so that magnetic bias fields HB are applied to the respective magnetic impedance elements 52a and 52b. The operating points of the magnetic impedance elements 52a and 52b are determined by the magnetic bias fields HB. The outputs of the respective impedance elements 52a and 52b are applied to the amplifier 63. The amplifier 63 determines the difference between the received signals. When the difference is determined, the components arising from the external magnetic field are cancelled. Thus the amplifier 63 outputs the resultant signal containing no external magnetic field component to the calculation unit 69 which in turn calculates the current I flowing through the electric wire and outputs the result.

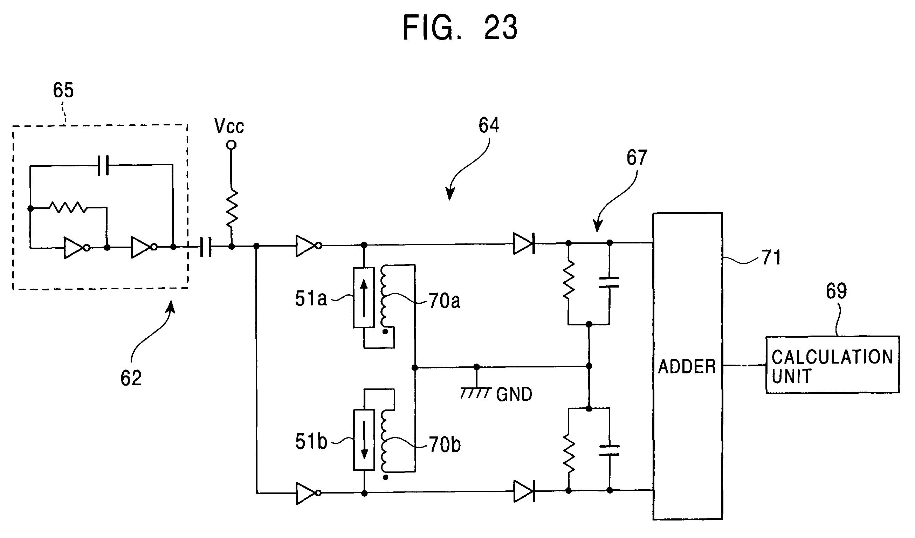

In the case where the magnetic impedance elements 51a and 51b are disposed such that they have a positive sensitivity in opposite directions, the disturbing external magnetic field component Hex is cancelled when the outputs of the magnetic impedance elements 51a and 51b are added together. More specifically, as shown in Fig. 23, the magnetic impedance elements 51a and 51b whose operating points are determined by the magnetic bias coils 70a and 70b, respectively, are driven by a current supplied by the driving circuit 62 having the oscillator 65, and voltages e corresponding to a magnetic field Hi are generated. When the voltages e are applied to the adder 71 via the rectifying circuit 67, the external magnetic filed component Hex is cancelled. The output of the adder 71 is sent to the calculation unit 69. The calculation unit 69 determines the current I flowing through the electric wire D and outputs the result.

As described above, because the magnetic impedance elements 51a and 51b (52a, 52b) are disposed such that they have a positive sensitivity in the same direction or opposite directions and such that the sensitivity directions are parallel to each other, when a uniform external magnetic field Hex is applied, the effects of the external magnetic field Hex upon the magnetic impedance elements 51a and 51b (52a, 52b) are equal, and thus it possible to cancel the external magnetic field Hex by determining the sum (or the difference) of the outputs of the respective magnetic impedance elements using the calculation unit 69. Thus, the detection result output from the calculation unit 60 does not include a component associated with the external magnetic field Hex.

Thus, the requirement for magnetic field blocking means such as a magnetic shield is minimized. As a result, it becomes possible to realize a high-sensitivity high-precision current sensor having a simple construction.

As described above, in the present invention, a high-sensitivity high-precision current sensor having a simple construction is realized by employing a high-sensitivity quick-response magnetic impedance element as a detection unit for detecting a magnetic field Hi generated around an electric wire through which a current to be detected is flowing.

## Claims

1. A current sensor comprising:

   a magnetic impedance element which is disposed a small distance apart from an electric wire through which a current to be detected is flowing so that said magnetic impedance element generates a voltage corresponding to the intensity of a magnetic field generated around said electric wire;
   a driving unit for supplying a current to said magnetic impedance element thereby driving said magnetic impedance element; and
   a calculation unit for determining the value of the current flowing through said electric wire from a voltage generated across said magnetic impedance element.

2. A current sensor comprising:

   a plurality of magnetic impedance elements which are each disposed a small distance apart from an electric wire through which a current to be detected is flowing so that said each magnetic impedance element generates a voltage corresponding to the intensity of a magnetic field generated around said electric wire;
   a driving unit for supplying a current to said plurality of magnetic impedance elements thereby driving said plurality of magnetic impedance elements; and
   a calculation unit for determining the value of the current flowing through said electric wire from voltages generated across said plurality of magnetic impedance elements.

3. A current sensor comprising:

   a magnetic impedance element which is formed in an annular ring shape surrounding an electric wire through which a current to be detected is flowing and which generates a voltage corresponding to the intensity of a magnetic field generated around said electric wire;
   a driving unit for supplying a current to said magnetic impedance element thereby driving said magnetic impedance element; and
   a calculation unit for determining the value of the current flowing through said electric wire from a voltage generated across said magnetic impedance element.

4. A current sensor according to Claim 2, wherein said plurality of magnetic impedance elements are disposed at opposite sides of said electric wire.

5. A current sensor according to Claim 4, wherein said plurality of magnetic impedance elements are disposed at opposite sides such that the sensitivity directions thereof become parallel to each other.

6. A current sensor comprising:

   a magnetic impedance element which is disposed a small distance apart from an electric wire through which a current to be detected is flowing so that said magnetic impedance element generates a voltage corresponding to the intensity of a magnetic field generated around said electric wire;
   a driving unit for supplying a current to said magnetic impedance element thereby driving said magnetic impedance element; and
   a calculation unit for determining the value of the current flowing through said electric wire from a voltage generated across said magnetic impedance element, said current sensor further comprising:
   a case made of a non-magnetic material, for firmly disposing said magnetic impedance element in said case;
   an electric wire holder formed in a part of said case so as to hold said electric wire; and
   a magnetic shield disposed along the perimeter of said case so as to block a magnetic field other than the magnetic field generated by said electric wire thereby preventing said magnetic impedance element from being disturbed by said magnetic field.

7. A current sensor comprising:

   a plurality of magnetic impedance elements which are each disposed a small distance apart from an electric wire through which a current to be detected is flowing so that said each magnetic impedance element generates a voltage corresponding to the intensity of a magnetic field generated around said electric wire;
   a driving unit for supplying a current to said plurality of magnetic impedance elements thereby driving said plurality of magnetic impedance elements; and
   a calculation unit for determining the value of the current flowing through said electric wire from voltages generated across said plurality of magnetic impedance elements, said current sensor further comprising:
   a case made of a non-magnetic material, for firmly disposing said plurality of magnetic impedance elements in said case;
   an electric wire holder formed in a part of said case so as to hold said electric wire; and
   a magnetic shield disposed along the perimeter of said case so as to block a magnetic field other than the magnetic field generated by said electric wire thereby preventing said plurality of magnetic impedance elements from being disturbed by said magnetic field.

8. A current sensor comprising:

a magnetic impedance element which is formed in an annular ring shape surrounding an electric wire through which a current to be detected is flowing and which generates a voltage corresponding to the intensity of a magnetic field generated around said electric wire; a driving unit for supplying a current to said magnetic impedance element thereby driving said magnetic impedance element; and a calculation unit for determining the value of the current flowing through said electric wire from a voltage generated across said magnetic impedance element, said current sensor further comprising: a case made of a non-magnetic material, for firmly disposing said magnetic impedance element in said case; an electric wire holder formed in the annular ring of said magnetic impedance element, for holding said electric wire; and a magnetic shield disposed along the perimeter of said case so as to block a magnetic field other than the magnetic field generated by said electric wire thereby preventing said magnetic impedance element from being disturbed by said magnetic field.

9. A current sensor comprising:

a plurality of magnetic impedance elements which are disposed at opposite sides of an electric wire through which a current to be detected is flowing so that said each magnetic impedance element generates a voltage corresponding to the intensity of a magnetic field generated around said electric wire; a driving unit for supplying a current to said plurality of magnetic impedance elements thereby driving said plurality of magnetic impedance elements; a calculation unit for determining the value of the current flowing through said electric wire from voltages generated across said plurality of magnetic impedance elements; and a guide for guiding said electric wire, said electric wire being guided such that it is located at the midpoint between said plurality of magnetic impedance elements disposed at opposite sides.

# FIG. 1A

# FIG. 1B

# FIG. 2

# FIG. 3

# FIG. 4

40

43

41

42

D

Hi

41

# FIG. 5

50

43

41

42

D

Hi

41

# FIG. 6

Hex

D

Hi

51a

51b

42

43

# FIG. 7

Hex

D

Hi

52a

52b

42

43

# FIG. 8

# FIG. 9

# FIG. 10

# FIG. 11

# FIG. 12

39

30

36

35

D

34

31

32

# FIG. 13

39

30

36a

35

D

37a

31 { 31a
     31b

32a } 32
32b

34

37b

36b

# FIG. 14

# FIG. 15

# FIG. 16

64

DRIVING CIRCUIT —62

AMPLIFIER —63

52b

52a

D

60

60

69

61

# FIG. 17

52b  D  52a

a

61

# FIG. 18

D

60

61

# FIG. 19A

# FIG. 19B

# FIG. 19C

# FIG. 20

EP 1 037 056 A1

# FIG. 21

EP 1 037 056 A1

# FIG. 22

EP 1 037 056 A1

# FIG. 23

EP 1 037 056 A1

# FIG. 24

**European Patent Office**

## EUROPEAN SEARCH REPORT

Application Number

EP 00 10 3840

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | PATENT ABSTRACTS OF JAPAN vol. 1998, no. 14, 31 December 1998 (1998-12-31) & JP 10 232259 A (MATSUSHITA ELECTRIC WORKS LTD), 2 September 1998 (1998-09-02) * abstract * | 1-3,6-9 | G01R15/14 G01R33/02 |

TECHNICAL FIELDS SEARCHED (Int.Cl.7)

G01R

The present search report has been drawn up for all claims

| Place of search | Date of completion of the search | Examiner |
|---|---|---|
| THE HAGUE | 8 June 2000 | Six, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 00 10 3840

This annex lists the patent family members relating to the patent documents cited in the above-mentioned European search report.
The members are as contained in the European Patent Office EDP file on
The European Patent Office is in no way liable for these particulars which are merely given for the purpose of information.

08-06-2000

| Patent document cited in search report | Publication date | Patent family member(s) | Publication date |
| --- | --- | --- | --- |
| JP 10232259 A | 02-09-1998 | NONE | |